# EUROPEAN PATENT APPLICATION

(11) **EP 4 343 020 A1**
(43) Date of publication of application: **27.03.2024**
(21) Application number: 22196803.5
(22) Date of filing: 21.09.2022
(51) Int. Cl.: C23C 16/04, G03F 7/16

(54) **METHOD OF FORMING A PATTERNED LAYER OF MATERIAL, APPARATUS FOR FORMING A PATTERNED LAYER OF MATERIAL**

(71) Applicant: ASML Netherlands B.V., 5500 AH Veldhoven (NL)
(72) Inventor: PARAYIL VENUGOPALAN, Syam, 5500 AH Veldhoven (NL); DE JAGER, Pieter, Willem, Herman, 5500 AH Veldhoven (NL); FARAMARZI, Vina, 5500 AH Veldhoven (NL)
(74) Representative: ASML Netherlands B.V.

(57) **Abstract**

The disclosure relates to methods and apparatus for forming a patterned layer of material on a substrate. In one arrangement, a selected portion of a surface of a substrate is irradiated during a deposition process. The irradiation locally drives the deposition process in the selected portion and thereby forms a patterned layer of material in a pattern defined by the selected portion. A bias voltage of alternating polarity is applied to the substrate during the irradiation to periodically drive secondary electrons generated inside the substrate by the irradiation towards the surface in the selected portion.

## Description

### FIELD

The present disclosure relates to methods and apparatus for forming a patterned layer of material. The methods and apparatus are particularly applicable to providing patterns of two-dimensional materials, for example for manufacturing FET devices.

### BACKGROUND

As semiconductor manufacturing processes continue to advance, the dimensions of circuit elements have continually been reduced while the amount of functional elements, such as transistors, per device has been steadily increasing, following a trend commonly referred to as 'Moore's law'. To keep up with Moore's law the semiconductor industry is seeking technologies that enable creation of increasingly smaller features.

For some types of electronic device, scaling down of the device features can cause performance challenges, such as the short-channel effect that occurs in MOSFETs when the channel length becomes comparable to the depletion layer widths of the source and drain junctions. These challenges can sometimes be addressed using two-dimensional materials, which are atomically thin and can have relatively low dielectric constants. Two-dimensional materials can have properties desirable for use in other contexts also. Two-dimensional materials may be used to replace gate oxide where a high dielectric constant is required. Two-dimensional materials may be used to replace interconnects where high conductivity is preferred.

Various deposition technologies exist for fabricating two-dimensional materials. Such deposition technologies include chemical vapor deposition (CVD), mechanical cleaving (exfoliation), molecular beam epitaxy (MBE), atomic layer deposition (ALD), liquid-phase exfoliation, and others. A challenge with many of these deposition technologies has been the high temperatures that are required for the processes to work efficiently (with high speed and quality). High temperatures can degrade or damage previously deposited layers and/or restrict the range of previously deposited layers that can be used. The previously deposited layers must be formed so that they can withstand the high temperatures to an acceptable degree, for example by having melting points above the temperatures reached during the deposition process.

In approaches based on exfoliation, the two-dimensional material can be grown offline without restrictions on temperature, but it is difficult to perform the exfoliation and transfer process with high throughput and low defectivity.

Patterning two-dimensional materials presents further challenges due to their fragile nature. Two-dimensional materials can be damaged or delaminated very easily. Two-dimensional materials can be damaged, for example, by traditional patterning processes such as resist coating, lithography, etch and resist stripping. Typical photoresists for DUV and EUV lithography may also be incompatible with two-dimensional materials, for example by being hydrophilic while the two-dimensional materials are hydrophobic. Even where great care is taken during processing, this physical incompatibility will result in unwanted sticking of resist residues on structures and a reduction in a quality of contact between the structures and other layers.

Laser etching has been proposed for patterning two-dimensional materials. Laser etching uses a laser to locally heat the surface to gradually melt material and remove the material by evaporation. Laser processing techniques rely on scanning from point to point, which lowers yield relative to some alternative approaches.

It is possible to induce deposition of material in a selected pattern using EUV radiation. However, it has proven difficult to achieve high throughput due to the need for very high EUV doses.

### SUMMARY

It is an object of the invention to provide alternative or improved methods and apparatus for forming a patterned layer of material on a substrate. It is a particular object to improve throughput and/or quality.

According to an aspect, there is provided an apparatus for forming a patterned layer of material on a substrate, comprising: a projection system configured to irradiate a selected portion of a surface of a substrate during a deposition process; an environment control system configured to contain the substrate in a controlled gaseous environment during the irradiation of selected portion, the controlled gaseous environment being such as to support the deposition process; and a bias voltage unit configured to apply a bias voltage of alternating polarity to the substrate during the irradiation to periodically drive secondary electrons generated inside the substrate by the irradiation towards the surface in the selected portion.

The apparatus may be configured such that the irradiation locally drives the deposition process in the selected portion and thereby forms a patterned layer of material in a pattern defined by the selected portion. The irradiation generates secondary electrons, and the bias voltage increases a proportion of the secondary electrons that can contribute to driving the deposition process. Configuring the bias voltage to have alternating polarity avoids excessive charge build up on the substrate. The bias voltage improves a rate of deposition per unit area, thereby improving throughput. The bias voltage can also improve spatial definition of the radiation induced deposition, thereby improving a quality of the pattern formed on the substrate.

In an embodiment, the irradiation comprises irradiation with electromagnetic radiation having a wavelength less than 100nm. This allows the secondary electrons to be generated efficiently and promotes high spatial resolution.

In an embodiment, the bias voltage has a non-sinusoidal bias voltage waveform. Providing a non-sinusoidal bias voltage makes it possible to reduce variations in the electric field in an internal volume of the substrate adjacent to the surface, thereby reducing a range of energies of secondary electrons driven to the surface. Reducing the range of energies of secondary electrons means that a greater proportion of the secondary electrons can contribute optimally to driving the deposition process, thereby improving throughput.

In an embodiment, the bias voltage waveform is periodic and each period comprises: a negative bias portion during which secondary electrons in the substrate are driven towards the surface in the selected portion; and a positive bias portion during which secondary electrons in the substrate are driven away from the surface in the selected portion. In such an arrangement, the voltage of the bias voltage waveform may furthermore be arranged to vary during at least a majority of the negative bias portion in such a manner as to at least partially compensate for charging of the substrate caused by impingement of ions onto the substrate from a plasma during the negative bias portion. Compensating for the charging of the substrate in this manner contributes to reducing the range of energies of secondary electrons impinging on the target layer by reducing variations in the electric field in an internal volume of the substrate adjacent to the surface in the selected portion.

In an embodiment, the variation of the voltage of the bias voltage waveform during the negative bias portion is substantially linear during at least a majority of the negative bias portion. This approach has been found to provide a good balance of ease of implementation and efficient compensation for charging of the substrate and reduction of variations in the electric field in the internal volume of the substrate adjacent to the surface in the selected portion.

In an embodiment, the variation of the voltage of the bias voltage waveform during the negative bias portion is such as to maintain a substantially time invariant electric field in an internal volume of the substrate adjacent to the surface of the substrate in the selected portion during the negative bias portion. Maintaining a substantially time invariant electric field in the internal volume adjacent to the surface promotes a high level of control of energies of secondary electrons reaching the surface, thereby promoting high throughput.

According to an aspect, there is provided a method of forming a patterned layer of material on a substrate, comprising: irradiating a selected portion of a surface of a substrate during a deposition process, the irradiation being such as to locally drive the deposition process in the selected portion and thereby form a patterned layer of material in a pattern defined by the selected portion; and applying a bias voltage of alternating polarity to the substrate during the irradiation to periodically drive secondary electrons generated inside the substrate by the irradiation towards the surface in the selected portion.

### BRIEF DESCRIPTION OF THE DRAWINGS

Embodiments of the invention will now be described, by way of example only, with reference to the accompanying schematic drawings, in which:
Figure 1 depicts a first example of a lithographic system comprising a lithographic apparatus and a radiation source;
Figure 2 depicts a second example of a lithographic system comprising a lithographic apparatus and a radiation source;
Figure 3 schematically depicts irradiation of a selected portion of a substrate to locally drive a deposition process;
Figure 4 schematically depicts formation of a patterned layer of material defined by the selected portion;
Figure 5 depicts an apparatus for forming a patterned layer of material;
Figure 6 schematically depicts average trajectories of secondary electrons from a focus region towards a surface of a substrate in the absence of a bias voltage applied to the substrate;
Figure 7 schematically depicts average trajectories of secondary electrons in the arrangement of Figure 6 with a bias voltage applied to the substate;
Figure 8 schematically depicts variation of substrate voltage against time in a transient phase shortly after an initial turning on of a bias voltage;
Figure 9 schematically depicts variation of substrate voltage against time in a steady state;
Figure 10 is a graph showing a distribution of energies of secondary electrons, plotted as the number of electrons at energy E, N(E), against E, for two different bias voltage waveforms;
Figure 11 is a graph showing a distribution of energies of secondary electrons where no bias voltage is applied, with superimposed rectangles showing approximate ranges of energies for which three different types of bond dissociations are favoured;
Figure 12 depicts an example non-sinusoidal bias voltage waveform;
Figure 13 is a graph showing three example non-sinusoidal bias voltage waveforms having different amplitudes;
Figure 14 is a graph showing distributions of energies of secondary electrons for the three bias voltage waveforms shown in Figure 13.

### DETAILED DESCRIPTION

A lithographic apparatus is a machine constructed to apply a desired pattern onto a substrate. A lithographic apparatus can be used, for example, in the manufacture of integrated circuits (ICs). A lithographic apparatus may, for example, project a pattern at a patterning device (e.g., a mask) onto a layer of radiation-sensitive material (resist) provided on a substrate.

To project a pattern on a substrate a lithographic apparatus may use electromagnetic radiation. The wavelength of this radiation determines the minimum size of features which are patterned on the substrate. Typical wavelengths currently in use are 365 nm (i-line), 248 nm, 193 nm and 13.5 nm. A lithographic apparatus which uses extreme ultraviolet (EUV) radiation, having a wavelength of less than 100nm, optionally in the range of 5-100 nm, optionally within a range of 4 nm to 20 nm, for example 6.7 nm or 13.5 nm, may be used to form smaller features on a substrate than a lithographic apparatus which uses, for example, radiation with a wavelength of 193 nm.

In the present document, the terms "radiation" and "beam" are used to encompass all types of electromagnetic radiation unless stated otherwise, including ultraviolet radiation (e.g. with a wavelength of 365, 248, 193, 157 or 126 nm) and EUV (extreme ultra-violet radiation, e.g. having a wavelength in the range of about 5-100 nm), as well as electron beam radiation.

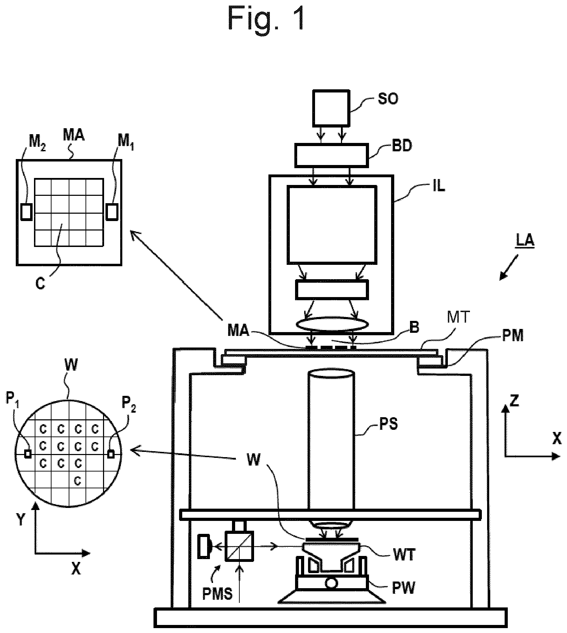

Figure 1 schematically depicts a lithographic apparatus LA. The lithographic apparatus LA includes an illumination system (also referred to as illuminator) IL configured to condition a radiation beam B (e.g., UV radiation, DUV radiation or EUV radiation), a mask support (e.g., a mask table) MT constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253, which is incorporated herein by reference.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support MT, and is patterned by the pattern (design layout) present on patterning device MA. Having traversed the mask MA, the radiation beam B passes through the projection system PS, which focuses the beam onto a target portion C of the substrate W. With the aid of the second positioner PW and a position measurement system IF, the substrate support WT can be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks PI, P2. Although the substrate alignment marks PI, P2 as illustrated occupy dedicated target portions, they may be located in spaces between target portions. Substrate alignment marks PI, P2 are known as scribe-lane alignment marks when these are located between the target portions C.

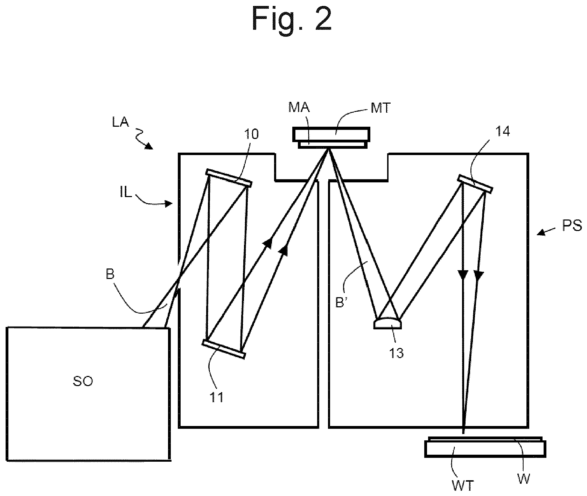

Figure 2 shows a lithographic system comprising a radiation source SO and a lithographic apparatus LA. The radiation source SO is configured to generate an EUV radiation beam B and to supply the EUV radiation beam B to the lithographic apparatus LA. The lithographic apparatus LA comprises an illumination system IL, a support structure MT configured to support a patterning device MA (e.g., a mask), a projection system PS and a substrate table WT configured to support a substrate W.

The illumination system IL is configured to condition the EUV radiation beam B before the EUV radiation beam B is incident upon the patterning device MA. Thereto, the illumination system IL may include a facetted field mirror device 10 and a facetted pupil mirror device 11. The faceted field mirror device 10 and faceted pupil mirror device 11 together provide the EUV radiation beam B with a desired cross-sectional shape and a desired intensity distribution. The illumination system IL may include other mirrors or devices in addition to, or instead of, the faceted field mirror device 10 and faceted pupil mirror device 11.

After being thus conditioned, the EUV radiation beam B interacts with the patterning device MA. As a result of this interaction, a patterned EUV radiation beam B' is generated. The projection system PS is configured to project the patterned EUV radiation beam B' onto the substrate W. For that purpose, the projection system PS may comprise a plurality of mirrors 13,14 which are configured to project the patterned EUV radiation beam B' onto the substrate W held by the substrate table WT. The projection system PS may apply a reduction factor to the patterned EUV radiation beam B', thus forming an image with features that are smaller than corresponding features on the patterning device MA. For example, a reduction factor of 4 or 8 may be applied. Although the projection system PS is illustrated as having only two mirrors 13,14 in Figure 2, the projection system PS may include a different number of mirrors (e.g. six or eight mirrors).

The substrate W may include previously formed patterns. Where this is the case, the lithographic apparatus LA aligns the image, formed by the patterned EUV radiation beam B', with a pattern previously formed on the substrate W.

A relative vacuum, i.e. a small amount of gas (e.g. hydrogen) at a pressure well below atmospheric pressure, may be provided in the radiation source SO, in the illumination system IL, and/or in the projection system PS.

The radiation source SO may be a laser produced plasma (LPP) source, a discharge produced plasma (DPP) source, a free electron laser (FEL) or any other radiation source that is capable of generating EUV radiation.

As mentioned in the introductory part of the description, although there is interest in using two-dimensional materials in semiconductor manufacturing processes, there are challenges in achieving sufficiently high crystalline quality and/or throughput and/or low defectivity. Deposition processes such as CVD and ALD require high temperatures, which can damage underlying layers. For example, typical CVD processes for producing high quality monolayers of two-dimensional crystals can require temperatures higher than 800°C, whereas temperatures above 500°C are typically incompatible with back end of the line CMOS technology. The thermal budget for Si FinFets (fin field-effect transistors), for example, is less than 1050°C for front end of the line (FEOL) and less than 400°C for back end of the line (BEOL). For 2D-FETs (field-effect transistors based on two-dimensional materials) this budget is much lower (typically 450-500°C for both FEOL and BEOL). Exfoliation-based processes avoid these thermal constraints because the deposition of the two-dimensional material can be performed at a separate location, but the transfer process is complex and it is difficult to avoid high defectivity. Traditional patterning processes such as resist coating, lithography, etch and resist stripping are also problematic because they can damage two-dimensional materials. Moreover, conventional lithography techniques represent a challenge for patterning 2D material layers. Due to the nature of these materials, the resulting structures are contaminated and/or damaged with rough edges after a lithography (DUV, EUV, EBL) followed by (dry-, wet-) etch step. Contacts to other layers e.g. source and drain electrodes are not optimal, resulting in a ~ 3.5 times larger Schottky barrier compared to where clean and sharp interfaces are provided.

An alternative approach using EUV-induced deposition can form patterns of two-dimensional material directly, without any resist processing. Examples of such deposition are described in WO2019166318, WO2020207759 and in EP3875633A1, all hereby incorporated in their entirety by reference. It can be difficult, however, with EUV-induced deposition to achieve sufficiently high growth rates of two-dimensional material. The EUV dose (the amount of energy deposited per unit area by the EUV radiation) is constrained in practice by throughput requirements. Typically, increasing the dose lowers throughput. A typical EUV dose limit may be 100 mJ/cm² for example.

Embodiments of the present disclosure provide methods and apparatus for forming a patterned layer 23 of material on a substrate W that address the above challenges. The forming of the patterned layer 23 involves irradiating the substrate W. The irradiation may be performed using any of the arrangements discussed above with reference to Figures 1 and 2. An apparatus for performing the methods may therefore comprise a projection system PS such as that described above with reference to Figures 1 and 2 configured to irradiate the substrate W by projecting a patterned beam of radiation onto the substrate W.

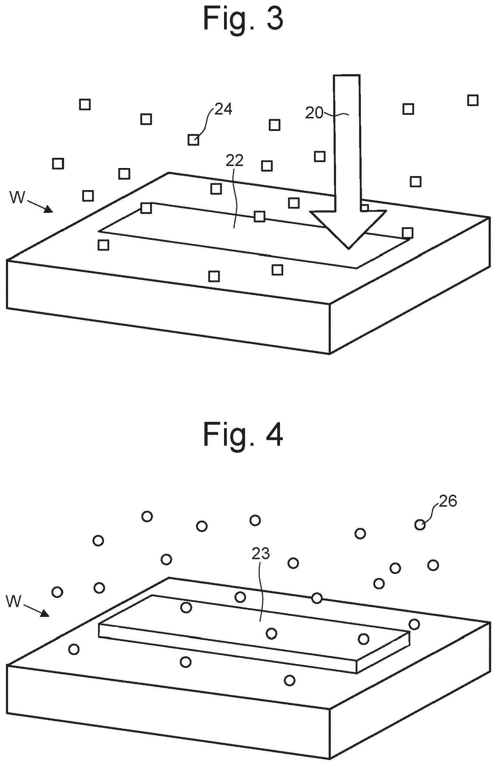

In some embodiments, as exemplified in Figures 3 and 4, the substrate W is irradiated during a deposition process to form the patterned layer 23. The method comprises irradiating 20 a selected portion 22 of a surface of the substrate W during the deposition process. The irradiation may thus apply a dose in the selected portion 22 and not in any other portion on the surface during at least one step of the deposition process. In an embodiment, the patterned layer 23 comprises, consists essentially of, or consists of, a two-dimensional material. A two-dimensional material is a material that shows significant anisotropy of properties in lateral directions within a plane of the material compared to the direction perpendicular to the plane of the material. A class of two-dimensional materials are sometimes referred to as single-layer materials, or monolayers, and may comprise crystalline materials consisting of a single layer of atoms or a small number of single layers of atoms on top of each other. In some embodiments, the two-dimensional material comprises, consists essentially of, or consists of, one or more of the following: one or more 2D allotropes such as graphene and antimonene; one or more inorganic compounds such as MXenes, hexagonal boron nitride (hBN), and a transition metal dichalcogenide (TMD) (a semiconductor of the type MX₂, which may be atomically thin, with the letter M referring to a transition metal atom (e.g. Mo or W) and the letter X referring to a chalcogen atom (e.g. S, Se, or Te)), for example WS₂, MoS₂, WSe₂, MoSe₂, etc. The two-dimensional material may comprise a layer of M atoms sandwiched between two layers of X atoms. The two-dimensional material may comprise any semiconductor two-dimensional material suitable for use as a transistor channel. As mentioned above, the two-dimensional material may compromise a 2D allotrope e.g. graphene or antimonene, or an inorganic compound. The two-dimensional material may comprise a monolayer (or multiple monolayers if the deposition process is repeated). In the embodiment shown, the deposition process is an atomic layer deposition process. In other embodiments, a different deposition process or combination of deposition processes is used, including for example one or more of the following independently or in combination: atomic layer deposition; chemical vapor deposition; plasma-enhanced chemical vapor deposition; epitaxy; sputtering; and electron beam-induced deposition. The formation of the patterned layer 23 may constitute a step in a method of forming at least one layer of a device to be manufactured, such as a semiconductor device. The two-dimensional material may, for example, form a channel of an FET or a metal cap or an interconnect or a diffusion barrier in an interconnect.

In an embodiment, the irradiation is performed with radiation that is capable of locally driving the deposition process. In an embodiment, the radiation comprises, consists essentially of, or consists of any type of EUV radiation (having a wavelength less than 100nm) that is capable of locally driving the deposition process. The use of EUV radiation provides high spatial resolution. In some other embodiments, the irradiation is performed with radiation comprising, consisting essentially of, or consisting of, higher wavelength radiation, optionally in combination with an immersion liquid, as described below. The higher wavelength radiation may be in the range of 100nm to 400nm (including DUV radiation).

The irradiation locally drives the deposition process in the selected portion 22 to cause the formation of the patterned layer 23, as depicted schematically in Figure 4. The pattern of the patterned layer 23 is defined by the selected portion 22. A pattern is thus formed without needing any resist. No processing to remove a resist is therefore required, which reduces the risk of damage to the patterned layer of material 30 or to any fragile underlying materials. This approach is particularly desirable where resist residue could significantly impact properties of a fragile underlying material and/or where lift-off of resist could significantly damage a fragile underlying material. Examples of fragile underlying materials include very thin film coatings, 2D materials such as graphene or transitional metal dichalcogenides (TMD), and free-standing membranes or thin films. In contrast to traditional lithography-based semiconductor manufacturing processes, instead of being used to break or cross-link molecules in a resist, radiation is being used to drive one or more chemical reactions involved in the deposition process.

Atomic layer deposition is a known thin-film deposition technique in which each of at least two chemicals (which may be referred to as precursor materials) are made to react with the surface of a material in a sequential, self-limiting, manner. In contrast to chemical vapor deposition, the two precursor materials are not normally present simultaneously above the substrate W.

In at least some embodiments using atomic layer deposition, the atomic layer deposition comprises at least a first step and a second step. In the first step, an example of which is depicted in Figure 3, a first precursor material 24 is made to react with a surface of a substrate W. In the second step, an example of which is depicted in Figure 4, a second precursor material 26 is made to react with the substrate W in a region where the first precursor 24 reacted with the substrate W in the first step (in this example the selected portions 22).

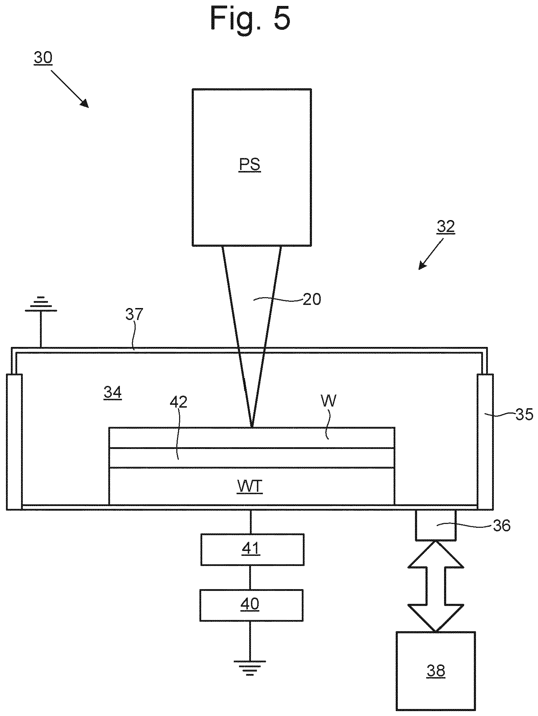

Figure 5 schematically depicts an apparatus 30 for performing the method. The apparatus 30 thus forms a patterned layer 23 of material on a substrate W. The apparatus 30 comprises a projection system PS. The projection system PS may form part of a lithographic apparatus LA. The projection system PS irradiates the selected portion 22 by projecting a patterned radiation beam from a patterning device MA onto the substrate W. The lithographic apparatus LA may be configured as described above with reference to Figure 1 (e.g., when the irradiation comprises DUV radiation and/or immersion lithography is required) or as described above with reference to Figure 2 (e.g., when the irradiation comprises EUV radiation).

In an embodiment, the lithographic apparatus LA is configured to perform immersion lithography. In such an embodiment, the atomic layer deposition process may comprise a step in which the selected portion 22 is irradiated while the selected portion 22 is in contact with an immersion liquid. Thus, for example, the atomic layer deposition process may comprise a first step comprising adsorption of a precursor from a gaseous precursor material to the substrate W and a second step in which the adsorbed precursor is modified in the selected portion 22 (e.g., to remove a by-product of the adsorption process) by irradiation through the immersion liquid. Any by-product produced by the irradiation through the immersion liquid can conveniently be carried away by flow of the immersion liquid. In an embodiment, the irradiated substrate W is subsequently dried and any further required processing is performed on the dried substrate W.

In an embodiment, an environment control system 32 is provided. The environment control system 32 allows the composition of the environment 34 above the substrate W to be controlled in such a way as to allow the deposition process to proceed. In an embodiment, the environment control system 32 comprises a chamber 35. The chamber 35 is configured to contain the substrate W in a controlled gaseous environment during the irradiation of the substrate W by the patterned beam. The chamber 35 may provide a sealed environment 34 including the selected portion 22 of the surface of the substrate W. The chamber 35 may comprise a pellicle 37 (e.g., a thin membrane) that is substantially transparent to the patterned beam 20 while still acting to limit or prevent movement of particles through the pellicle 37. The pellicle 37 may for example seal the chamber 35 and be substantially transparent to EUV radiation. The patterned radiation beam passes through the pellicle 37 onto the target layer 22 during the irradiation. The chamber 35 should typically be capable of maintaining the controlled gaseous environment at a pressure substantially below atmospheric pressure. The chamber 35 may be configured to provide conditions similar to those provided in an EUV scanner vacuum environment for example.

In some embodiments, all of the substrate W will be within the chamber 35 during the deposition process (e.g., atomic deposition process). In an embodiment, a materials exchange system 36 (e.g., a port into the chamber 35 and associated valves and/or conduits) is provided that allows materials to be added to and removed from the sealed environment 34 to allow different compositional environments to be established within the sealed environment 34. Materials may be provided to and from the materials exchange system 36 by a flow manager 38. The flow manager 38 may comprise any suitable combination of reservoirs, ducting, valves, sinks, pumps, control systems, and/or other components necessary to provide the required flows of materials into and out of the chamber. The different compositional environments achieved in this way may correspond to different respective stages of the deposition process. In some embodiments, the materials added to and removed from the chamber are gaseous, thereby providing compositional environments consisting of different combinations of gases. In an embodiment in which one or more steps of the deposition process are performed by irradiating the substrate W through an immersion liquid, the environment control system 36 may be configured to allow switching between a state in which a controlled liquid environment is maintained above the substrate W (e.g. during exposure in an immersion lithography mode) and a state in which a controlled gaseous environment is maintained above the substrate W (e.g. during adsorption of a precursor from a gaseous precursor material).

In some embodiments, the driving of the deposition process in the selected portion 22 comprises driving a chemical reaction involving a precursor material. The precursor material will be provided as part of the compositional environment established above the substrate W during the irradiation. The driving of the chemical reaction may cause the chemical reaction to proceed at a faster rate than would be the case in the absence of the irradiation. Alternatively, the chemical reaction may be such that it would not occur at all in the absence of the irradiation. In an embodiment, the chemical reaction is endothermic, and the irradiation provides the energy necessary to allow the chemical reaction to proceed. In some embodiments, the chemical reaction is at least partially driven by heat generated in the substrate W by the irradiation. Thus, the chemical reaction being driven by the irradiation may comprise a chemical reaction that requires an elevated temperature to proceed or which proceeds more rapidly at elevated temperatures. In some embodiments, the chemical reaction comprises a photochemical reaction driven by the irradiation. Thus, at least one species involved in the chemical reaction directly absorbs a photon from the irradiation and the absorption of the photon allows the chemical reaction to proceed. In some embodiments, the photochemical reaction comprises a multiphoton photochemical reaction involving absorption of two or more photons by each of at least one species involved in the photochemical reaction. The requirement for two or more photons to be absorbed makes the chemical reaction much more sensitive to variations in the intensity of the irradiation (i.e., the rate of the chemical reaction varies much more strongly as a function of intensity) than would be the case for single photon photochemical reactions. The increased sensitivity to intensity provides improved lateral contrast. In an embodiment, a combination of a photochemical reaction and radiation induced heating is used to provide a well-defined process window in which the chemical reaction is driven locally to produce the pattern. In an embodiment, the chemical reaction is driven by a plasma generated by interaction between the radiation and the substrate W, a layer formed on the substrate W, and/or a gas present above the substrate. In an embodiment, the generated plasma is generated in a localized region defined by the irradiation. In an embodiment, the chemical reaction is driven by electrons provided by the irradiation. The electrons may comprise photoelectrons or secondary electrons (electrons generated by inelastic scattering events of a photoelectron or of electrons from an e-beam). In an embodiment, photons absorbed by the substrate W may provide energetic electrons near the surface of the substrate W that participate in the deposition process (e.g., secondary electrons, as described below). In embodiments where a combination of electromagnetic radiation and an e-beam is used, a portion of the deposition process may be driven by electrons from the e-beam.

In some embodiments, flow dynamics of gaseous/liquid co-reactants and/or catalysts and/or precursors are controlled during the deposition process. The control of the flow dynamics can improve the quality of material deposited. The control of flow dynamics may include controlling a direction of the flow (or a vector flow field of the flow). Alternatively or additionally the control of flow dynamics may include controlling a rate of the flow, including for example providing a pulsed flow. In an embodiment, the control of flow dynamics is performed so as to create locally in space and/or time a high density of relevant particles near the deposition location and a low density of the particles near other surfaces (e.g., optics).

In some embodiments, the compositional environment is controlled to provide different mixtures of gases at different times. The different mixtures of gases may be provided to deposit different materials or to switch between a mode where material is deposited and a mode in which material is etched away. The different mixtures of gases may also be used to controllably vary a rate of deposition as a function of time, which may be useful for example to create features with well-defined edges and/or shapes.

In some embodiments, a bias voltage is applied to the substrate W during the irradiation. The bias voltage may be applied using a bias voltage unit 40 as depicted schematically in Figure 5. The bias voltage unit 40 may comprise a voltage source configurable to provide a desired bias voltage waveform. In the arrangement shown, the substrate W is attached to a substrate table WT via an electrostatic chuck 42. The bias voltage unit 40 can apply the bias voltage indirectly by applying a voltage to the substrate table WT and/or electrostatic chuck 42 or can apply the bias voltage directly to the substrate W (e.g., from a side of the substrate W opposite to the selected portion 22 of the surface of the substrate W that is irradiated). The bias voltage may be applied via a matching box or blocking capacitor network 41. As explained below, the bias voltage may increase the extent to which secondary electrons generated by irradiation contribute to driving of a deposition process in the selected portion 22, thereby increasing a rate of the deposition process and improving yield. The bias voltage may achieve this by increasing the proportion of the secondary electrons that reach the surface of the substrate W with suitable energies and/or trajectories.

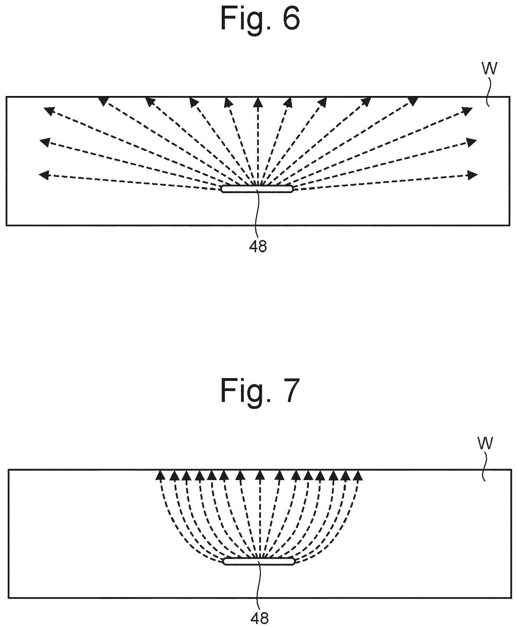

Figures 6 and 7 schematically depict average trajectories (broken line arrows) of secondary electrons from a focus region 48 towards a surface of a substrate W. Figure 6 represents the case where no bias voltage is applied. Figure 7 represents the case where a bias voltage is applied. In each case, the secondary electrons may be generated by photons of the irradiation interacting with the substrate material to generate primary electrons of relatively high energy. The primary electrons then interact further with the substrate material to generate lower energy secondary electrons. A portion of the secondary electrons generated in the substrate W will reach the surface with energies and trajectories suitable for escaping from the surface and contributing to driving of a deposition process at the surface of the substrate W. The secondary electrons may, for example, drive the deposition by causing dissociation of precursor molecules at the surface. The dissociation of the precursor molecules may drive chemical reactions that result in deposition of desired material on the surface.

In the situation represented in Figure 6, where no bias voltage is applied, a portion of the secondary electrons originating from irradiation of the focus region 48 reach the surface of the substrate W but the secondary electrons are relatively spread out. A relatively large proportion of the secondary electrons also arrive at the surface with relatively shallow trajectories (e.g., trajectories that are closer to being parallel to the surface of the substrate than perpendicular to the surface of the substrate). Secondary electrons that reach the surface with energies lower than the work function will be reflected and cannot contribute to inducing deposition of material on the surface. Secondary electrons that reach the surface with energies higher than the work function but at shallow trajectories may also be reflected if the energy associated with the component of propagation perpendicular to the surface is less than the work function.

In the situation represented in Figure 7, where a bias voltage is applied, the bias voltage results in an electric field being established between the focus region 48 and the surface. A maximum magnitude of the electric field will depend on the amplitude of the bias voltage waveform. Electric fields in the range of a few GV/m can be achieved in the substrate W and will be sufficient to modify trajectories of secondary electrons strongly enough to have a useful effect. It has been found, for example, that a thin substrate of SiO₂ deposited by ALD techniques can withstand electric fields of few GV/m without breakdown. The electric field changes trajectories of the secondary electrons such that the secondary electrons impinge on the surface at steeper angles and in a more confined region. This results in a greater proportion of the secondary electrons being able to overcome the work function and contribute to inducing deposition of material on the surface. Additionally, the electric field focuses the secondary electrons into a more spatially constrained region on the surface, thereby increasing an intensity of secondary electrons reaching the surface. A rate of radiation induced deposition per unit area is thus increased by the applied bias voltage. Additionally, the bias voltage promotes improved spatial definition of the radiation induced deposition, thereby improving a quality of the pattern formed on the substrate W by the radiation induced deposition.

In an embodiment, the bias voltage has alternating polarity. The bias voltage thus repeatedly changes sign. The bias voltage may be defined by a periodic (regularly repeating) bias voltage waveform. The bias voltage periodically drives secondary electrons generated inside the substrate by the irradiation towards the surface in the selected portion 22. Using a bias voltage with alternating polarity limits charging of the substrate W during the irradiation. Excessive build up of charge on the substrate W is undesirable because it could lead to deposition being induced over a wider area than desired, for example independently of the pattern defined by the irradiation (e.g., outside of the selected portion 22).

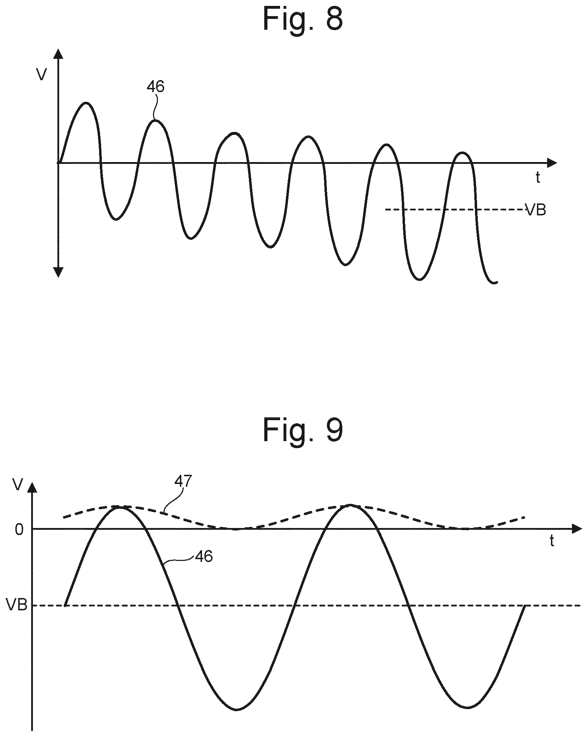

In some embodiments, the bias voltage waveform is sinusoidal. Figures 8 and 9 schematically depict example curves 46 showing variation of voltage at the surface of the substrate W against time during application of the sinusoidal bias voltage waveform. Figure 8 depicts a transient phase immediately after the bias voltage waveform is first applied. Figure 9 depicts a steady state regime that is reached after a short time. As shown Figure 8, the voltage at the surface may drift during the transient phase as the surface becomes negatively charged due to a greater mobility of relatively light negatively charged electrons in a plasma created outside of the substrate by the irradiation in comparison with heavier positively charged ions of the plasma. In the presence of a well-tuned matching box or blocking capacitor network 41, the voltage drifts until the waveform is such that no net charging of the surface occurs when considered over a whole cycle (period) of the applied bias voltage waveform. The DC shift observed in the steady state may be referred to as a DC bias voltage.

The energies of ions impinging on the substrate W from a plasma above the substrate W will depend on how the electric field varies in a sheath volume adjacent to the substrate W during the applied bias voltage. This electric field depends on the difference in voltage between the bulk of the plasma and the voltage at the surface of the substrate W. The voltage in the bulk of the plasma varies relatively little as a function of time in comparison to the voltage in the sheath volume nearer to substrate W. Curve 47 in Figure 9 depicts schematically how the voltage in the bulk of the plasma is expected to vary as a function of time. The voltage in the bulk of the plasma varies with a much smaller amplitude than the voltage in the substrate W.

The bias voltage applied to the substrate W generates an electric field both within the substrate W and in the sheath volume adjacent to the substrate W. The electric field will have the same polarity in both regions and will thus drive movement of electrons in both regions in the same sense. Thus, when electrons in the plasma are driven towards the substrate W the secondary electrons inside the substrate W will be driven away from the surface of the substrate in the selected portion (i.e., downwards in the orientation of Figure 5). When positive ions in the plasma are driven towards the substrate W the secondary electrons in the substrate W will be driven towards the surface of the substrate W in the selected portion 22. Thus, the distribution of energies of secondary electrons driven to the surface in the selected portion 22 by the applied bias voltage will be similar in form to the distribution of energies of ions driven towards the surface by the applied bias voltage.

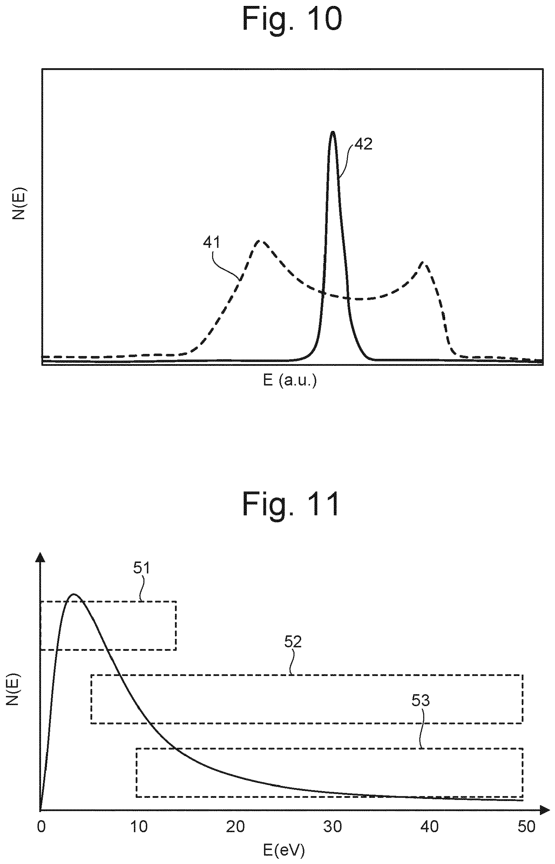

When a sinusoidal bias voltage is applied, the electric field varies as a function of time in a manner that leads to a relatively wide and bimodal spread in the distribution of energies of secondary electrons reaching the surface. This is depicted schematically in curve 41 of Figure 10, which shows a distribution in energies, N(E), as a function of secondary electron energy (E) for the case of a sinusoidal applied bias voltage. Curve 41 is relatively wide (spread over a relatively large range of energies) and is bimodal (has two distinct local minima). The distribution of energies of secondary electrons can be shifted along the energy axis by varying the amplitude of the bias voltage waveform.

In some embodiments, a non-sinusoidal bias voltage waveform is applied. Applying a non-sinusoidal bias voltage provides flexibility to achieve a distribution of energies of the secondary electrons that is more favorable for inducing the desired deposition in the selected portion 22 on the surface of the substrate W. For example, the bias voltage waveform may be tailored such that a large proportion of the secondary electrons reaching the surface of the substrate W in the selected portion 22 have an energy within a range that promotes one or more favored mechanisms of interaction with precursor material. This may be facilitated by selecting the bias voltage waveform to provide a distribution of energies of secondary electrons reaching the surface that has a single maximum (rather than multiple local maxima). Such a distribution of energies may be referred to as a mono-modal distribution.

A favored mechanism of interaction may comprise a favored type of bond dissociation. Figure 11 is a graph showing a typical distribution of secondary electron energies at the surface for a case where no bias voltage is applied. The range of energies is relatively wide with a peak in the range of 3-5eV. Superimposed on the graph are broken line rectangles 51-53 showing approximate ranges of energies for which three different types of bond dissociations are favoured. Rectangle 51 depicts a range of energies that favor dissociative electron detachment (DEA). Rectangle 52 depicts a range of energies that favour neutral dissociation (ND). Rectangle 53 depicts a range of energies that favour dissociative ionization (DI). Applying a sinusoidal bias voltage waveform may provide a range of secondary electrons at higher energies than is the case where no bias voltage is applied. For example, instead of most of the secondary electrons reaching the surface with energies less than 10eV (in the DEA regime), applying the bias voltage may allow most of the secondary electrons that reach the surface to do so with energies above 10eV, optionally above 20eV, optionally above 30eV, optionally above 40eV, optionally in the range of 10eV to 52eV (in the ND and DI regimes), and/or with energies that favor neutral dissociation (ND) and/or dissociative ionization (DI) of precursor material more than dissociative electron detachment (DEA). This may provide an improvement relative to the non-biased case by promoting the ND and DI mechanisms relative to the DEA mechanism, which may be favorable for a range of different deposition processes. However, as discussed above with reference to Figure 10, the energy distribution achieved with sinusoidal biasing may still be relatively spread out, such that a significant proportion of the secondary electrons may reach the surface with energies that are too low to favor desired bond dissociation mechanisms (e.g., ND and DI). Tailoring a non-sinusoidal bias voltage waveform to provide a narrower spread in the distribution of energies of the secondary electrons may allow a larger proportion of the secondary electrons to contribute in the most effective way to promoting the deposition process. Using a non-sinusoidal bias voltage waveform may therefore improve throughput.

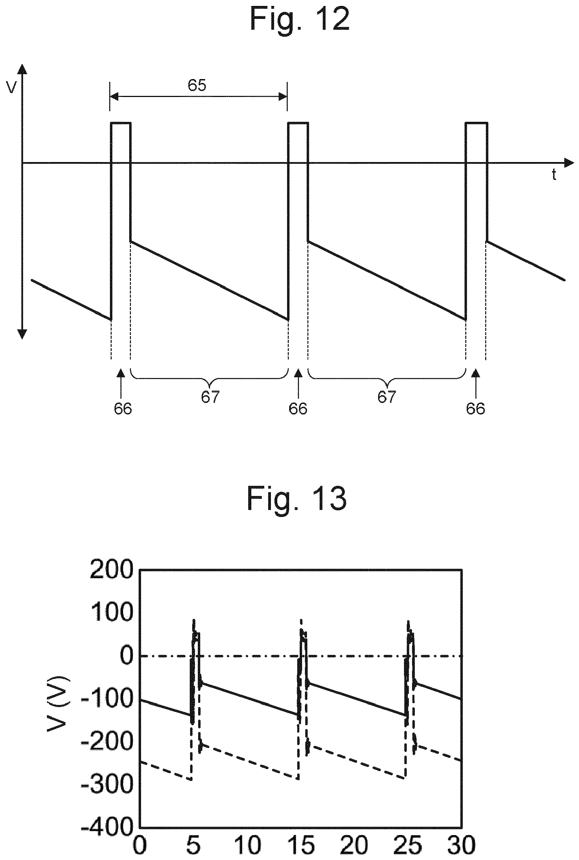

In an embodiment, the non-sinusoidal bias voltage waveform is periodic. An example of such a bias voltage waveform is shown in Figure 12. The curve in Figure 12 represents the variation of the applied voltage in the steady state described above with reference to Figure 9. No significant net charging of the substrate W occurs over a period 65 of the applied voltage waveform in the steady state. Each period 65 of the bias voltage waveform comprises a positive bias portion 66 and a negative bias portion 67. A sum of the durations of the positive bias portion 66 and the negative bias portion 67 may equal the period 65 of the bias voltage waveform.

The voltage applied during the negative bias portion 67 is such that secondary electrons in the substrate W are driven towards the surface of the substrate W in the selected portion 22 (i.e., the upper side of the substrate W in the orientation of Figure 5) during the negative bias portion. Thus, an electrical potential at the surface of the substrate W is higher than an electrical potential within the bulk of the substrate W during the negative bias portion. At the same time, positive ions of the plasma outside the substrate W may be attracted towards the substrate 22.

The voltage applied during the positive bias portion 66 is such that secondary electrons in the substrate W are driven away from the surface of the substrate W in the selected portion 22 during the positive bias portion 66. Thus, an electrical potential at the surface of the substrate W is lower than an electrical potential within the bulk of the substrate W during the positive bias portion. At the same time, electrons of the plasma outside of the substrate W may be attracted towards the target layer 22.

The low masses of the electrons in the plasma means the electrons will respond very quickly to changes in the direction of the electric field and will in essence flow onto the substrate W only during the positive bias portion 66. By contrast, the much heavier ions will flow onto the substrate W not only during the negative bias portion 67 but also during at least a portion of the positive bias portion 66 due to inertial effects. In some embodiments, the duration of the positive bias portion is selected (e.g., is sufficiently short) such that ions continue to flow to the target layer due to inertial effects during all of the positive bias portion.

In some embodiments, as exemplified in Figure 12, the duration of the positive bias portion 66 is shorter than the duration of the negative bias portion 67. The positive bias portion 66 may, for example, be less than one quarter of the period 65 of the bias voltage waveform, preferably less than 1/5 of the period 65, preferably less than 1/6 of the period 65, preferably less than 1/8 of the period 65, preferably less than 1/10 of the period.

In some embodiments, the voltage of the bias voltage waveform is substantially constant during at least a majority of the positive bias portion 66.

In some embodiments, the voltage of the bias voltage waveform varies during at least a majority of the negative bias portion 67 in such a manner as to at least partially compensate for charging of the target layer 22 and/or substrate 24 caused by impingement of the ions during the negative bias portion. Charging may occur for example where the surface and/or a layer below the surface is dielectric. Arranging for the bias voltage to compensate the charging decreases variation of the electric field in the internal volume of the substrate W adjacent to the surface in the selected portion 22, thereby contributing to a reduced spread of energies in the distribution of energies of secondary electrons reaching the surface.

In some embodiments, as exemplified in Figure 12, the variation of the voltage of the bias voltage waveform during the negative bias portion 67 is substantially linear during at least a majority of the negative bias portion 67 (as shown in Figure 12). In some embodiments, the variation of the voltage of the bias voltage waveform during the negative bias portion 67 is such as to maintain a substantially time invariant electric field in an internal volume of the substrate W adjacent to the surface in the selected portion 22 during the negative bias portion 67.

Use of a non-sinusoidal bias voltage waveform facilities provision of a distribution of energies of secondary electrons that has a single maximum (mono-modal), as exemplified by curve 42 in Figure 10, or plural local maxima that are close together in energy. The non-sinusoidal bias voltage waveform thus facilities provision of a distribution of energies of secondary electrons that has a high proportion in a range that favors optimal dissociation mechanisms (e.g., the ND and DI mechanisms discussed above). For example, the bias voltage waveform may be selected such that a single maximum is provided above 10eV, optionally above 20eV, optionally above 30eV, optionally above 40eV, optionally in the range of 10eV to 52eV.

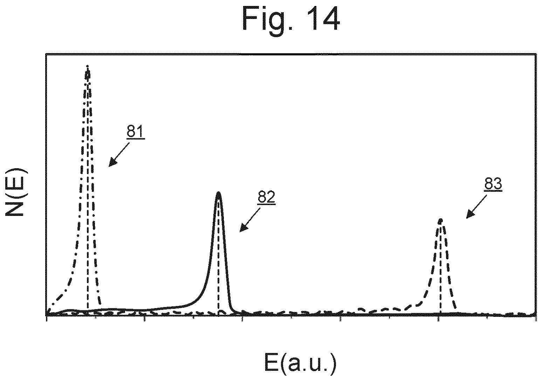

As explained above in the context of sinusoidal bias voltage waveforms, the distribution of energies of ions can be shifted along the energy axis by varying the amplitude of the bias voltage waveform. This is illustrated in Figure 13. In Figure 13, three different bias voltage waveforms are shown with three different amplitudes and the same frequency. Figure 14 shows corresponding distributions of secondary electron energies. Curve 81 (dot-dash line) shows the distribution of energies resulting from applying the lowest amplitude bias voltage waveform in Figure 13. Curve 82 (solid line) shows the distribution of energies resulting from applying the intermediate amplitude bias voltage waveform in Figure 13. Curve 83 (broken line) shows the distribution of energies resulting from applying the highest amplitude bias voltage waveform in Figure 13. The curves 81-83 are example mono-modal curves of the same type as curve 42 shown in Figure 10. The mono-modal form is achieved by using the respective non-sinusoidal waveforms shown in Figure 13. In contrast to the sinusoidal case discussed above with reference to Figures 8-10, as the amplitude is increased it is seen that the spread of energies neither increases significantly in width nor becomes bimodal. The non-sinusoidal bias voltage waveform therefore allows flexible control of the distribution of energies of secondary electrons without the distribution becoming spread out or bimodal. The energies of the secondary electrons can thus be tuned flexibly to be within a small range of an optimal energy for inducing the particular deposition process being used.

In some embodiments, the bias voltage applied by the bias voltage unit 40 comprises a radio frequency waveform. In some embodiments, the frequency of the bias voltage waveform is less than 1 MHz.

The inventors have performed simulations to calculate the magnitude of improvement in throughput that is made possible by applying the bias voltage. The maximum improvement theoretically possible varies according to the composition of the material being deposited and the substrate. However, improvements in the range of 50 to 300 are typically found. For example, for deposition of W on a SiO₂ substrate using a tailored square wave bias voltage and irradiation with EUV radiation it is expected that an improvement in throughput of greater than 200 could be achieved. For deposition of W on a Sn substrate using the same parameters, an improvement in throughput of greater than about 100 is expected. In both cases, applying the bias voltage allows a sufficiently high throughput to be achieved for the approach to be practical using currently available EUV lithography apparatuses and currently achievable EUV doses.

Embodiments of the disclosure are defined in the following numbered clauses.
1. An apparatus for forming a patterned layer of material on a substrate, comprising:
   a projection system configured to irradiate a selected portion of a surface of a substrate during a deposition process;
   an environment control system configured to contain the substrate in a controlled gaseous environment during the irradiation of selected portion, the controlled gaseous environment being such as to support the deposition process; and
   a bias voltage unit configured to apply a bias voltage of alternating polarity to the substrate during the irradiation to periodically drive secondary electrons generated inside the substrate by the irradiation towards the surface in the selected portion.
2. The apparatus of clause 1, wherein the bias voltage has a non-sinusoidal bias voltage waveform.
3. The apparatus of clause 2, wherein the bias voltage waveform is periodic.
4. The apparatus of clause 3, wherein each period comprises:
   a negative bias portion during which secondary electrons in the substrate are driven towards the surface in the selected portion; and
   a positive bias portion during which secondary electrons in the substrate are driven away from the surface in the selected portion.
5. The apparatus of clause 4, wherein the bias voltage unit is configured such that the voltage of the bias voltage waveform varies during at least a majority of the negative bias portion in such a manner as to at least partially compensate for charging of the substrate caused by impingement of ions onto the substrate from a plasma during the negative bias portion.
6. The apparatus of clause 5, wherein the bias voltage unit is configured such that the variation of the voltage of the bias voltage waveform during the negative bias portion is substantially linear during at least a majority of the negative bias portion.
7. The apparatus of clause 5 or 6, wherein the bias voltage unit is configured such that the variation of the voltage of the bias voltage waveform during the negative bias portion is such as to maintain a substantially time invariant electric field in an internal volume of the substrate adjacent to the surface in the selected portion during the negative bias portion.
8. The apparatus of any of clauses 4-7, wherein the duration of the positive bias portion is less than 1/4 of the period of the bias voltage waveform.
9. The apparatus of any of clauses 4-8, wherein the voltage of the bias voltage waveform is substantially constant during at least a majority of the positive bias portion.
10. The apparatus of any preceding numbered clause, wherein the bias voltage unit is configured such that the bias voltage has a bias voltage waveform selected to provide a distribution of energies of secondary electrons reaching the surface in the selected portion that has a single maximum.
11. The apparatus of any preceding numbered clause, wherein the bias voltage unit is configured such that the bias voltage has a bias voltage waveform selected to provide a distribution of energies of secondary electrons reaching the surface in the selected portion in which most of the secondary electrons have energies above 10eV and/or energies that favor neutral dissociation and/or dissociative ionization of precursor material more than dissociative electron detachment.
12. The apparatus of any preceding numbered clause, wherein the projection system is configured to irradiate the selected portion with electromagnetic radiation having a wavelength less than 100nm.
13. The apparatus of any preceding numbered clause, wherein the projection system and environment control system are configured such that the irradiation generates a plasma outside of the substrate.
14. The apparatus of any preceding numbered clause, wherein the projection system and environment control system are configured such that the irradiation locally drives the deposition process in the selected portion and thereby forms a patterned layer of material in a pattern defined by the selected portion, the patterned layer optionally comprising a two-dimensional material.
15. A method of forming a patterned layer of material on a substrate, comprising:
   irradiating a selected portion of a surface of a substrate during a deposition process, the irradiation being such as to locally drive the deposition process in the selected portion and thereby form a patterned layer of material in a pattern defined by the selected portion; and
   applying a bias voltage of alternating polarity to the substrate during the irradiation to periodically drive secondary electrons generated inside the substrate by the irradiation towards the surface in the selected portion.
16. The method of clause 15, wherein the bias voltage has a non-sinusoidal bias voltage waveform.
17. The method of clause 16, wherein the bias voltage waveform is periodic.
18. The method of clause 17, wherein each period comprises:
   a negative bias portion during which secondary electrons in the substrate are driven towards the surface in the selected portion; and
   a positive bias portion during which secondary electrons in the substrate are driven away from the surface in the selected portion.
19. The method of clause 18, wherein the voltage of the bias voltage waveform varies during at least a majority of the negative bias portion in such a manner as to at least partially compensate for charging of the substrate caused by impingement of ions onto the substrate from a plasma during the negative bias portion.
20. The method of clause 19, wherein the variation of the voltage of the bias voltage waveform during the negative bias portion is substantially linear during at least a majority of the negative bias portion.
21. The method of clause 19 or 20, wherein the variation of the voltage of the bias voltage waveform during the negative bias portion is such as to maintain a substantially time invariant electric field in an internal volume of the substrate adjacent to the surface in the selected portion during the negative bias portion.
22. The method of any of clauses 18-21, wherein the duration of the positive bias portion is less than 1/4 of the period of the bias voltage waveform.
23. The method of any of clauses 18-22, wherein the voltage of the bias voltage waveform is substantially constant during at least a majority of the positive bias portion.
24. The method of any of clauses 15-23, wherein the bias voltage has a bias voltage waveform selected to provide a distribution of energies of secondary electrons reaching the surface in the selected portion that has a single maximum.
25. The method of any of clauses 15-24, wherein the bias voltage has a bias voltage waveform selected to provide a distribution of energies of secondary electrons reaching the surface in the selected portion in which most of the secondary electrons have energies above 10eV and/or energies that favor neutral dissociation and/or dissociative ionization of precursor material more than dissociative electron detachment.
26. The method of any of clauses 15-25, wherein the irradiation comprises irradiation with electromagnetic radiation having a wavelength less than 100nm.
27. The method of any of clauses 15-26, wherein the irradiation generates a plasma outside of the substrate.
28. The method of any of clauses 15-27, wherein the patterned layer comprises a two-dimensional material.

## Claims

1. An apparatus for forming a patterned layer of material on a substrate, comprising:
a projection system configured to irradiate a selected portion of a surface of a substrate during a deposition process;
an environment control system configured to contain the substrate in a controlled gaseous environment during the irradiation of selected portion, the controlled gaseous environment being such as to support the deposition process; and
a bias voltage unit configured to apply a bias voltage of alternating polarity to the substrate during the irradiation to periodically drive secondary electrons generated inside the substrate by the irradiation towards the surface in the selected portion.

2. The apparatus of claim 1, wherein the bias voltage has a non-sinusoidal bias voltage waveform.

3. The apparatus of claim 2, wherein the bias voltage waveform is periodic.

4. The apparatus of claim 3, wherein each period comprises:
a negative bias portion during which secondary electrons in the substrate are driven towards the surface in the selected portion; and
a positive bias portion during which secondary electrons in the substrate are driven away from the surface in the selected portion.

5. The apparatus of claim 4, wherein the bias voltage unit is configured such that the voltage of the bias voltage waveform varies during at least a majority of the negative bias portion in such a manner as to at least partially compensate for charging of the substrate caused by impingement of ions onto the substrate from a plasma during the negative bias portion.

6. The apparatus of claim 5, wherein the bias voltage unit is configured such that the variation of the voltage of the bias voltage waveform during the negative bias portion is substantially linear during at least a majority of the negative bias portion.

7. The apparatus of claim 5 or 6, wherein the bias voltage unit is configured such that the variation of the voltage of the bias voltage waveform during the negative bias portion is such as to maintain a substantially time invariant electric field in an internal volume of the substrate adjacent to the surface in the selected portion during the negative bias portion.

8. The apparatus of any of claims 4-7, wherein the duration of the positive bias portion is less than 1/4 of the period of the bias voltage waveform.

9. The apparatus of any of claims 4-8, wherein the voltage of the bias voltage waveform is substantially constant during at least a majority of the positive bias portion.

10. The apparatus of any preceding claim, wherein the bias voltage unit is configured such that the bias voltage has a bias voltage waveform selected to provide a distribution of energies of secondary electrons reaching the surface in the selected portion that has a single maximum.

11. The apparatus of any preceding claim, wherein the bias voltage unit is configured such that the bias voltage has a bias voltage waveform selected to provide a distribution of energies of secondary electrons reaching the surface in the selected portion in which most of the secondary electrons have energies above 10eV and/or energies that favor neutral dissociation and/or dissociative ionization of precursor material more than dissociative electron detachment.

12. The apparatus of any preceding claim, wherein the projection system is configured to irradiate the selected portion with electromagnetic radiation having a wavelength less than 100nm.

13. The apparatus of any preceding claim, wherein the projection system and environment control system are configured such that the irradiation generates a plasma outside of the substrate.

14. The apparatus of any preceding claim, wherein the projection system and environment control system are configured such that the irradiation locally drives the deposition process in the selected portion and thereby forms a patterned layer of material in a pattern defined by the selected portion, the patterned layer optionally comprising a two-dimensional material.

15. A method of forming a patterned layer of material on a substrate, comprising:
irradiating a selected portion of a surface of a substrate during a deposition process, the irradiation being such as to locally drive the deposition process in the selected portion and thereby form a patterned layer of material in a pattern defined by the selected portion; and
applying a bias voltage of alternating polarity to the substrate during the irradiation to periodically drive secondary electrons generated inside the substrate by the irradiation towards the surface in the selected portion.
